(19) Europäisches Patentamt

European Patent Office

Office européen des brevets

(11) EP 0 795 957 B1

(12) FASCICULE DE BREVET EUROPEEN

(45) Date de publication et mention
de la délivrance du brevet:
**11.06.2003 Bulletin 2003/24**

(51) Int Cl.⁷: **H03H 7/21**

(21) Numéro de dépôt: **97200726.4**

(22) Date de dépôt: **11.03.1997**

(54) **Dispositif incluant un circuit coupleur passif déphaseur de 180 degrés**

Vorrichtung mit einer passiven um 180 Grad phasenverschiebenden Kopplungsschaltung

Device comprising a passive, 180 degree phase-shifting coupling circuit

(84) Etats contractants désignés:
**DE FR GB**

(30) Priorité: **13.03.1996 FR 9603154
19.12.1996 FR 9615666**

(43) Date de publication de la demande:
**17.09.1997 Bulletin 1997/38**

(73) Titulaire: **Koninklijke Philips Electronics N.V.
5621 BA Eindhoven (NL)**

(72) Inventeurs:
• **Jean, Patrick
75008 Paris (FR)**
• **Boyavalle, Christophe
75008 Paris (FR)**

(74) Mandataire: **Lottin, Claudine
Société Civile S.P.I.D.
156, Boulevard Haussmann
75008 Paris (FR)**

(56) Documents cités:
**EP-A- 0 355 979        US-A- 5 023 576
US-A- 5 469 129**

• **RADIO AND ELECTRONIC ENGINEER, vol. 54,
no. 11/12, Novembre 1984, LONDON GB, pages
473-489, XP002032789 R.G.MANTON: "Hybrid
networks and their use in radio-frequency
circuits"**

## Description

L'invention concerne un dispositif incluant un circuit coupleur passif, déphaseur de 180°.

L'invention trouve son application dans l'industrie des circuits intégrés, et en particulier dans l'industrie des circuits hyperfréquences monolithiquement intégrés (MMIC).

Un circuit coupleur passif pour mélangeurs hyperfréquences est déjà connu d'un ouvrage d'enseignement général intitulé "MICROWAVE MIXERS, Second Edition" par Stephen A. MAAS, publié chez "Artech House, Boston, London".

Ce document décrit p.254, en relation avec une FIG.7.16a, un coupleur 180° comprenant quatre sections en Π et en T qui modélisent des éléments de lignes de transmission pour rendre ce circuit équivalent à une structure décrite en relation avec une FIG.7.14. Les sections en Π comportent une self-inductance entre deux capacités à la masse, et la section en T comporte deux capacités en série et une self-inductance à la masse. Les sections en Π modélisent des lignes quart-d'onde, et les sections en T modélisent des lignes trois-quart d'onde.

D'autres cicuits coupleurs passifs déphaseur de 180° sont connus du document US-A-5 023 576 et du document RADIO AND ELECTRONIC ENGINEER, vol. 54, no. 11/12, Novembre 1984, LONDON GB, pages 473-489, R.G.MANTON: 'Hybrid networks and their use in radio-frequency circuits'.

Un objet de la présente invention est de fournir un dispositif comprenant un circuit coupleur passif à éléments localisés pour coupler au moins un signal alternatif primaire à deux signaux alternatifs secondaires déphasés de 180°.

Un objet de l'invention est de fournir un tel dispositif compatible avec les circuits intégrés hyperfréquences monolithiquement intégrés et donc qui présente une plus faible surface et/ou des performances améliorées par rapport aux coupleurs connus de l'état de la technique.

Ces problèmes sont résolus par un dispositif incluant un circuit coupleur passif à éléments localisés, pour coupler un premier signal alternatif de fréquence centrale donnée présent sur un premier port primaire à deux seconds signaux alternatifs déphasés de 180° présents sur deux ports secondaires, comprenant un premier et un second circuits élémentaires déphaseurs de 180° ayant respectivement un pôle d'entrée différentiel et un pôle d'entrée sommateur, et des premier et second pôles de sortie correspondants, lesdits circuits élémentaires étant connectés entre eux de manière que le pôle d'entrée différentiel du premier circuit fournit ledit premier port primaire, le pôle d'entrée différentiel du second circuit fournit un second port primaire relié à la masse par une impédance, que les pôles de sortie du premier et du second circuit sont respectivement couplés en croix et fournissent lesdits ports secondaires, et que les pôles d'entrée sommateurs sont court-circuités.

Les figures schématiques suivantes illustrent des exemples de réalisation de circuits coupleurs et de dispositifs selon l'invention, dont

- les FIGS.1A, 1B et 1C représentent un premier circuit élémentaire déphaseur de 180° à éléments localisés dans différentes formes de réalisations équivalentes, et les FIGS.2A, 2B et 2C représentent un second circuit élémentaire déphaseur correspondant ;
- les FIGS.3A à 3D représentent des cellules élémentaires de circuits déphasants ;
- la FIG.4A et 4B représentent des schémas de montages des premier et second circuits déphaseurs pour constituer un circuit coupleur symétrique déphaseur de 180° ;
- les FIGS.5A à 5C représentent deux exemples de réalisation de circuits coupleurs symétriques simplifiés déphaseurs de 180° ;
- la FIG.6 représente un schéma de montage pour constituer un circuit coupleur asymétrique déphaseur de 180° ;
- les FIGS.7A et 7B représentent deux exemples de réalisation de circuits coupleurs asymétriques déphaseurs de 180° ;
- les FIGS.8A et 8B sont respectivement des schémas équivalents des coupleurs symétriques et asymétriques précédents ;
- la FIG.9 représente un dispositif du type amplificateur équilibré incluant deux des coupleurs précédents.

On décrit ci-après plusieurs circuits coupleurs passifs à éléments localisés. Chaque circuit coupleur passif effectue un couplage entre un premier signal alternatif de fréquence centrale donnée fo, présent sur un premier port primaire P1, et deux seconds signaux alternatifs déphasés de 180°, présents sur deux ports secondaires P3,P4. Selon l'invention, un circuit coupleur comprend un premier et un second circuits élémentaires B,B' déphaseurs de 180°, à éléments localisés, connectés d'une manière particulière.

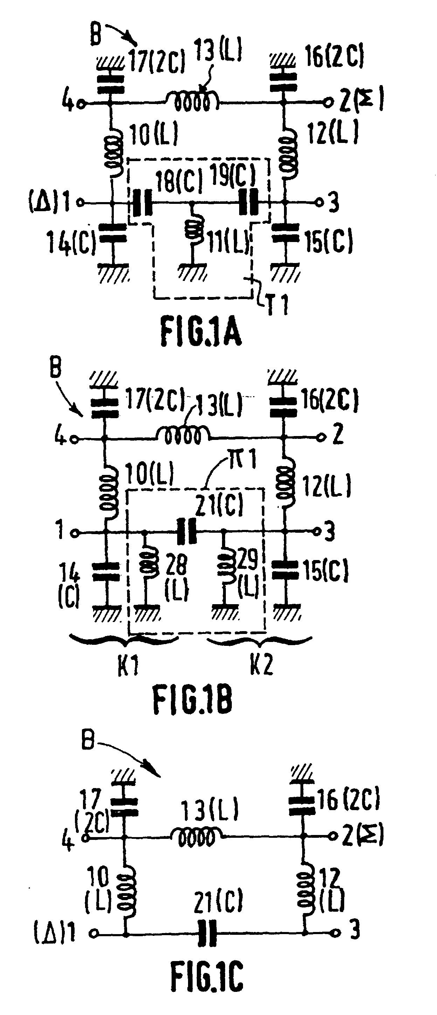

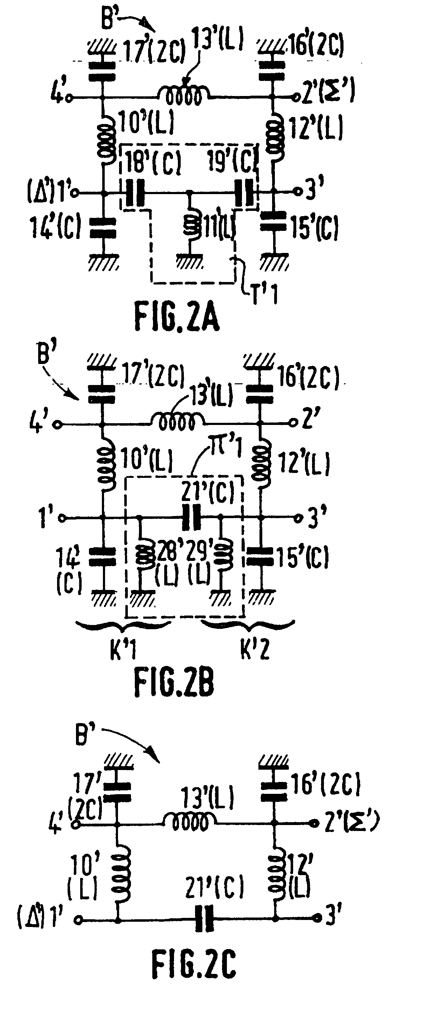

Tels que représentés respectivement par les schémas des FIG.1A et 2A, les circuits élémentaires B, B' ont respectivement un premier et un second pôles 1,2 et 1',2' d'entrée et un premier et un second pôles de sortie 3,4 et 3',4' qui sont respectivement diamétralement opposées. Les circuits B,B' élémentaires comprennent une association de selfs de valeur L notées 10,13,12, et notées 10',13',12', arrangées entre les pôles 1,4,2,3 et 1',4',2',3' respectivement, et de capacités de valeur C notées 14,15 et notées 14',15' respectivement reliant les pôles 1,3 et 1',3' à la masse, et de capacités 16,17 et 16',17' de valeur 2C reliant les pôles 2,4 et 2',4' à la masse. Le produit des valeurs de self L et capacités C est lié à la fréquence centrale fo par la relation :

$$L\omega = 1/C\omega$$

où $\omega = 2\pi fo$.

Entre les pôles 1,3 et 1',3' respectivement, les circuits élémentaires comportent des cellules en T telles que représentées sur la FIG.3A, notées T1, T'1, formées respectivement d'une self 11,11' de valeur L, reliée à la masse et disposée entre deux capacités 18,19 et 18',19' de valeur C, formant par exemple des cellules $3\lambda/4$ où $\lambda$ est la longueur d'onde associée à fo.

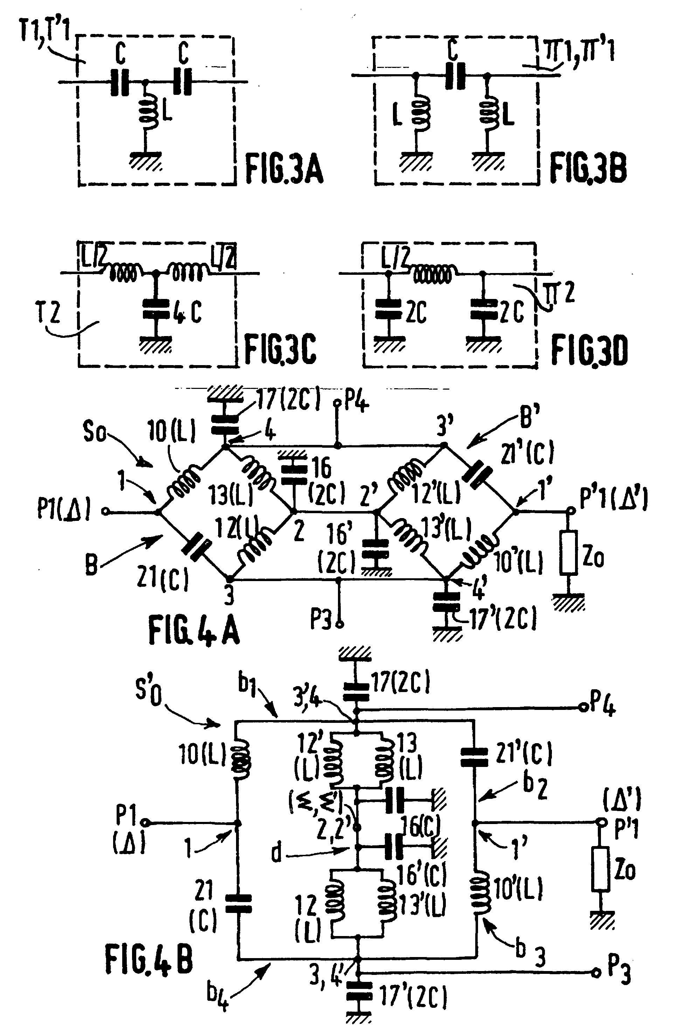

En référence aux FIG.1B et 2B, les schémas de circuits élémentaires B,B' sont respectivement transformés en remplaçant les cellules T1, T'1 par des cellules en $\Pi$ telles que représentées sur la FIG.3B et notées $\Pi1$, $\Pi'1$, formées respectivement d'une capacité 21,21' de valeur C, disposée entre deux selfs 28,29 et 28',29' reliées à la masse, formant par exemple des cellules $3\lambda/4$.

Les schémas de circuits élémentaires B, B' comprenant ces cellules en $\Pi$ sont simplifiés en prenant en compte que les selfs L et capacités C en parallèle à la masse forment des cellules L-C notées K, telles que les cellules 28-14, 28'-14', 29-15, et 29'-15', formant respectivement les cellules K1, K'1, K2 et K'2. Ces cellules L-C sont considérées équivalentes à des circuits ouverts à la fréquence centrale fo, d'où il résulte les schémas de circuits élémentaires B,B' représentés sur les FIGS.1C et 2C.

Selon l'invention, chaque couple de circuits B, B' élémentaires décrit précédemment peut être utilisé indifféremment pour constituer un coupleur selon l'invention par un montage particulier décrit ci-après. Des transformations de cellules en T en cellules en $\Pi$, et des simplifications mettant des cellules L-C en circuit ouvert peuvent être faites après ce montage particulier, lorsque ces modifications n'ont pas été faites auparavant.

Ces circuits élémentaires passifs à élément localisés B,B' constituent une famille de déphaseurs qui ont pour fonction :

de fournir entre leurs premier et second pôles de sortie, notées 3,3' et 4,4', des signaux déphasés de 180° lorsqu'on applique un signal alternatif sur leur premier pôle d'entrée, appelé différentiel $\Delta,\Delta'$ noté ici 1,1',

et de fournir un signal sommé sur leur second pôle d'entrée, appelé sommateur $\Sigma,\Sigma'$ noté ici 2,2', lorsqu'on applique des signaux en phase sur leur bornes de sortie 3,3' et 4,4' respectivement.

Ces propriétés sont utilisées pour ledit montage particulier selon l'invention.

Un premier exemple concerne des circuits coupleurs symétriques dérivés de l'arrangement particulier du couple de circuits élémentaires simplifiés B, B' représentés sur les FIGS.1C et 2C. En référence à la FIG.4A, pour former un coupleur symétrique déphaseur de 180° noté So, les circuits déphaseurs élémentaires B,B' sont connectés de manière que le signal alternatif à coupler est appliqué sur le pôle différentiel d'entrée 1 du premier circuit élémentaire B formant un premier port primaire P1 ; les premiers pôles de sortie 3',3 des circuits élémentaires sont reliés en croix aux seconds pôles de sortie 4,4' respectivement, pour constituer un premier et un second ports secondaires P4,P3 ; les pôles sommateurs d'entrée 2 et 2' des deux circuits élémentaires sont reliées ; le pôle différentiel d'entrée 1' du second circuit élémentaire B' forme un second port primaire P'1 relié à la masse par une impédance Zo liée à la fréquence centrale. Par exemple cette impédance Zo est une résistance Ro liée par la relation :

$$L\omega = 1/C\omega = 2\sqrt{2}\ Ro$$

où par exemple Ro = 50 $\Omega$.

En référence à la FIG.4B, le schéma de circuit So de la FIG.4A est simplifié selon un schéma S'o dans lequel les selfs 12, 13' et 13,12' de valeur L des circuits déphaseurs élémentaires B,B' sont montées en parallèle, et les capacités 16,16' de valeur 2C sont montées en parallèle. Le premier et le second ports secondaires P4,P3 sont portés à la masse à travers respectivement les capacités 17 et 17' de valeur 2C. En référence aux FIGS.5A à 5C, le schéma de circuit coupleur simplifié S'o de la FIG.4B résulte en deux modes de réalisation de coupleurs symétriques selon l'invention.

En référence à la FIG.5A, dans un premier mode de réalisation de coupleur symétrique noté S, les selfs 12, 13' et 13, 12' de valeur L des circuits déphaseurs élémentaires B,B' montées en parallèle résultent en des selfs 33,32 de valeur moitié L/2, et les capacités 16,16' de valeur 2C montées en parallèle résultent en une capacité 26 de valeur double 4C. La cellule formée de la capacité 26 de valeur 4C disposée entre les selfs 32,33 de valeur L/2 est une cellule élémentaire en T, par exemple $3\lambda/4$, notée T2, telle que représentée sur la FIG.3C.

En référence à la FIG.5C, dans un second mode de réalisation de coupleur symétrique noté S', la cellule T2 est remplacée par une cellule élémentaire en $\Pi$, notée $\Pi$ 2, par exemple $3\lambda/4$, telle que représentée sur la FIG.3D et formée d'une self 36 de valeur L/2 disposée entre deux capacités 43, 42 de valeurs 2C.

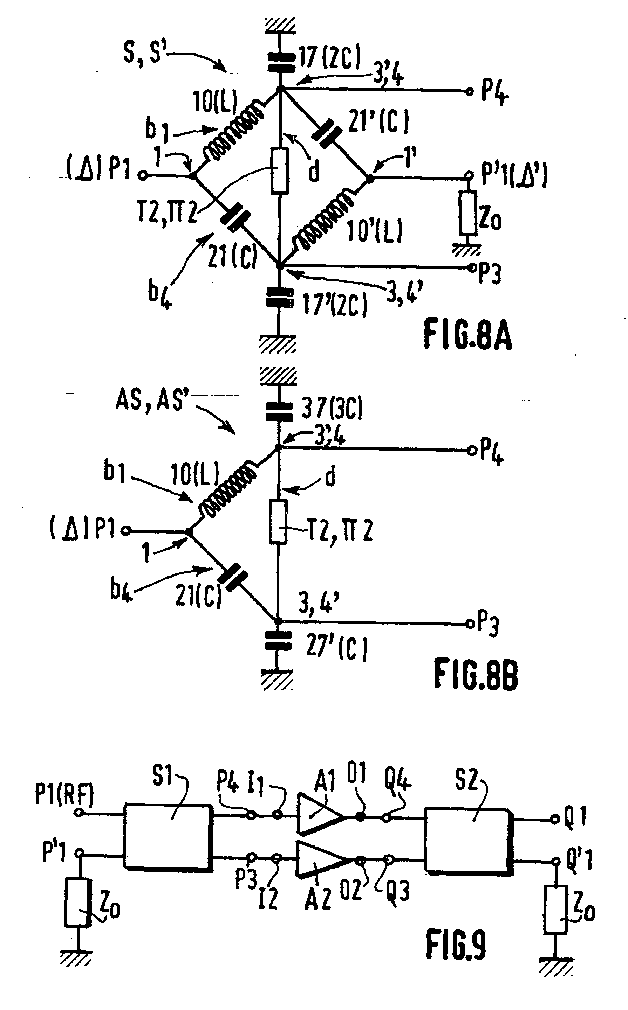

Ainsi agencés et tels que représentés par le schéma de la FIG.8A, les coupleurs simplifiés S et S' comprennent 4 branches connectées b1, b2, b3 et b4 formant une structure circulaire sur laquelle les ports primaires P1, P'1 et secondaires P4, P3 sont disposés respectivement de manière diamétralement opposée et symétrique. Les ports secondaires P4, P3 sont reliés par une branche transversale d formée soit de la cellule élémentaire T2, soit de la cellule élémentaire $\Pi$ 2 et sont en outre respectivement reliés à la masse à travers les capacités 17, 17' de valeur 2C. Le premier port primaire P1 est pour le signal alternatif et le second port primaire P'1 est relié à la masse à travers l'impédance Zo.

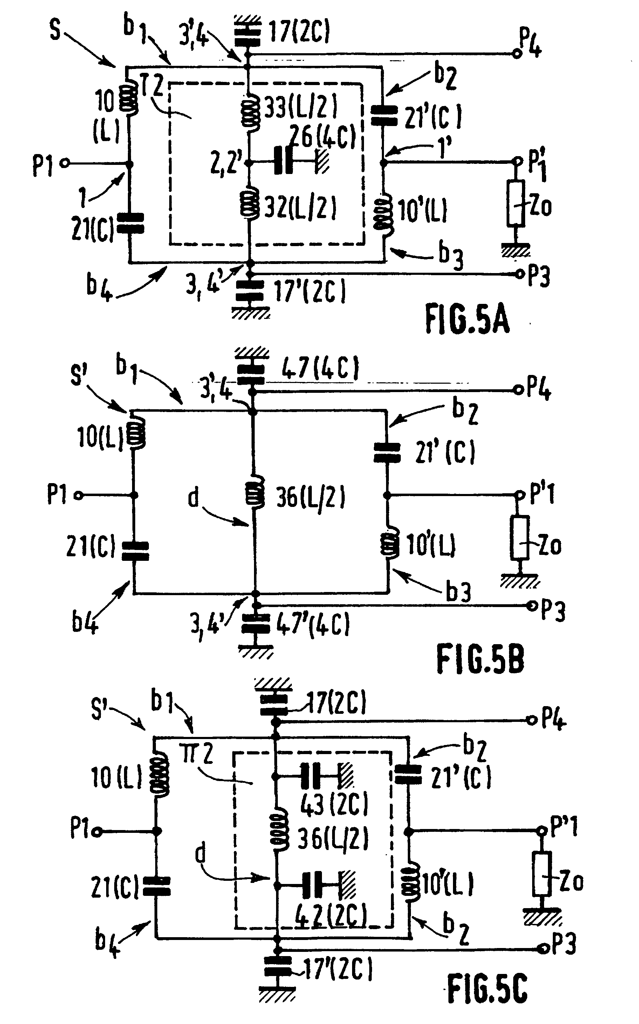

En référence aux FIGS.5A, 5B, la structure circulaire est formée des branches b1, b2, b3 et b4 comportant une alternance de selfs 10,10' de valeur L dans les branches opposées b1,b3 et de capacités 21,21' de valeur C dans les branches opposées b2,b4. La branche transversale d comprend des cellules T2 ou Π 2 comme déjà décrit. Dans le circuit S comportant la branche transversale d avec T2, les ports secondaires P4, P3 sont reliés à la masse par des capacités 17, 17' de valeur 2C, comme montré sur la FIG.5A. Dans le circuit coupleur S' comportant la branche transversale d avec Π 2, ladite branche d est réduite à la self 36 de valeur L/2, et les ports secondaires P4, P3 sont reliés à la masse par des capacités 47, 47' de valeur 4C par regroupement des capacités 43 et 42, provenant de la branche transversale d en Π, avec les capacités respectivement parallèles 17, 17', comme montré sur la FIG.5B.

Un second exemple concerne des circuits coupleurs asymétriques aptes à fournir des signaux de sortie déphasés de 180°. Ces circuits coupleurs sont dérivés d'arrangements particuliers simplifiés des circuits S, S' des FIG.5A et 5B.

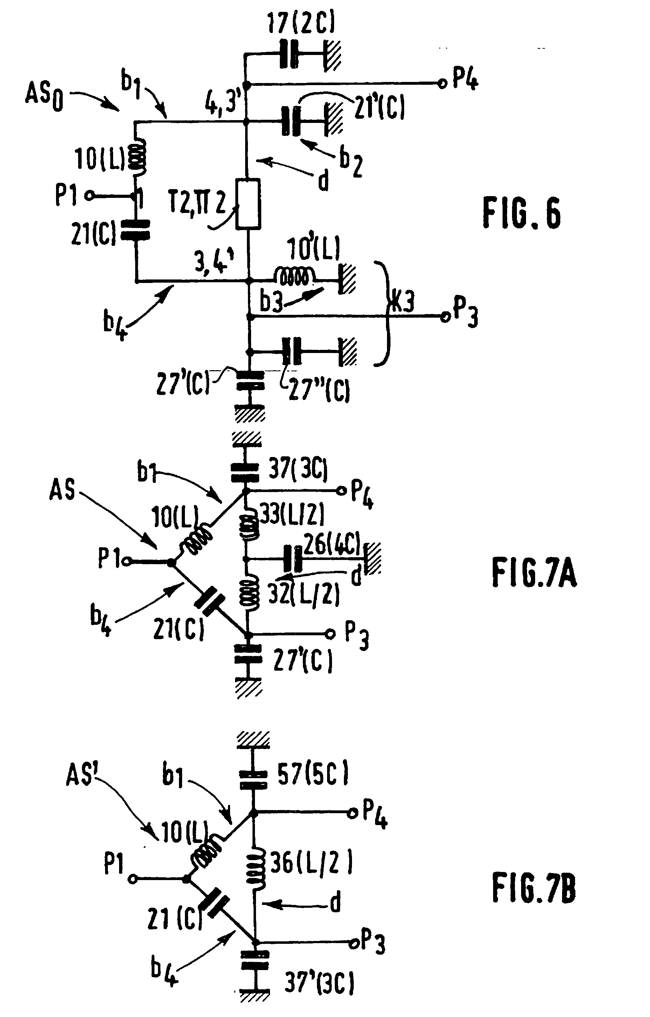

En référence à la FIG.6, dans les circuits S et S', le second port primaire P'1 est court-circuité à la masse (Zo = 0), résultant en un schéma de circuit coupleur ASo asymétrique. La branche b2 est constituée de la capacité 21' de valeur C, reliée à la masse, et disposée en parallèle à la capacité 17 de valeur 2C, et la branche b3 est constituée de la self 10' de valeur L reliée à la masse. Dans cet arrangement particulier, la capacité 17' de valeur 2C est dédoublée en deux capacités parallèles 27' et 27" chacune de valeur C. La capacité 27" est associée à la self 10' de valeur L pour former une cellule K3 considérée comme un circuit ouvert comme déjà décrit, pour fournir les schémas de circuits coupleurs AS,AS'.

En référence aux FIGS. 7A et 7B, dans deux modes de réalisation, les circuits coupleurs asymétriques AS et AS' comprennent deux branches b1, b4 s'étendant du seul port primaire P1 aux ports secondaires P3, P4 et comportant respectivement une self 10 de valeur L et une capacité 21 de valeur C. Les ports secondaires sont connectés par une branche transversale d comme décrite dans le premier exemple. Dans le circuit AS les ports secondaires P4, P3 sont reliés à la masse par la capacité 37 de valeur 3C regroupant les capacités parallèles 17, 21', et par la capacité 27' de valeur C. Dans le circuit AS', les ports secondaires sont reliés à la masse par la capacité 57 de valeur 5C regroupant les capacités parallèles 17, 21' et 43, et par la capacité 37' de valeur 3C regroupant les capacités parallèles 27' et 42.

Dans la réalisation de dispositifs par exemple semiconducteurs, et en particulier pour systèmes de télécommunication, incluant un des circuits coupleurs selon l'invention tel que proposé par exemple sur les FIGS.

5A, 5B et 8A, 8B, des avantages tiennent en ce que ces circuits sont compacts, les selfs sont faibles, ce qui réduit d'autant les pertes, le nombre des points de masse est diminué par rapport aux coupleurs connus de l'état de la technique ce qui améliore les performances en haute et hyperfréquences, facilite les connexions et rend l'intégration plus aisée et la fiabilité de ces dispositifs plus grande.

Ces circuits coupleurs sont très avantageux dans des bandes de fréquence se trouvant dans la région des hautes fréquences ( environ 100 MHz à quelques GHz ) ou des hyperfréquences ( environ 1 GHz à 30 GHz ). Ces circuits coupleurs tels que S et S' sont large bande. Par exemple le circuit S' de la FIG.5B pourra montrer une bande passante de 750 MHz à 1,1 GHz ou bien de 24 GHz à 40 GHz.

Les circuits coupleurs asymétriques présentent des pertes théoriques réduites à zéro du fait que Zo = 0. Les coupleurs symétriques sont très avantageux pour présenter des signaux complémentaires à des mélangeurs doublement équilibrés utiles dans des systèmes de télécommunication.

En référence à la FIG.9, dans un troisième exemple, un dispositif comprend deux coupleurs notés S1,S2 d'un des types décrit dans l'un des exemples précédents, associés à deux amplificateurs notés A1,A2 d'un type connu de l'homme du métier, pour former un dispositif amplificateur équilibré utile dans des systèmes de télécommunication, en particulier pour les récepteurs radiofréquence. Par exemple un signal radiofréquence RF est appliqué au premier port primaire P1 du coupleur S1. Les ports secondaires P4,P3 sont reliés aux entrées I1,I2 des deux amplificateurs A1,A2 dont les sorties 01,02 sont reliées aux ports secondaires Q4,Q3 du second coupleur S2. La sortie de l'amplificateur équilibré ainsi formé est disponible sur le premier port différentiel du second coupleur S2. Les seconds ports primaires P'1,Q'1 sont reliés à la masse à travers une impédance Zo.

Les circuits et dispositifs décrits plus haut sont favorablement réalisés en technologie des dispositifs semiconducteurs hyperfréquences monolithiquement intégrés (MMICs).

**Revendications**

1. Dispositif incluant un circuit coupleur passif à éléments localisés pour coupler un premier signal alternatif de fréquence centrale donnée (fo) présent sur un premier port primaire (P1) à deux seconds signaux alternatifs déphasés de 180° présents sur deux ports secondaires (P3,P4), comprenant un premier et un second circuits élémentaires (B,B') déphaseurs de 180° ayant respectivement un pôle d'entrée différentiel (1,1') et un pôle d'entrée sommateur (2,2') et des premier et second pôles de sortie (3,4;3',4'), lesdits circuits élémentaires étant connectés entre eux de manière que le pôle d'entrée différentiel (1) du premier circuit (B) fournit ledit premier port primaire (P1), le pôle (1') d'entrée différentiel du second circuit (B') fournit un second port primaire (P'1) relié à la masse par une impédance (Zo), que les pôles de sortie (3,4;4',3') du premier et du second circuit (B,B') sont respectivement couplés en croix et fournissent lesdits ports secondaires (P3,P4), et que les pôles d'entrée sommateurs (2,2') sont court-circuités.

2. Dispositif selon la revendication 1, dans lequel, dans ledit coupleur, les premier et second circuits élémentaires déphaseurs connectés sont arrangés selon un circuit symétrique comprenant quatre branches (b1,b2,b3,b4) connectées formant une structure circulaire, avec les ports primaires et secondaires disposés respectivement de manière diamétralement opposée et symétrique sur ladite structure, et avec une branche transversale (d) connectant les deux ports secondaires (P3,P4).

3. Dispositif selon la revendication 2, dans lequel les branches connectées (b1,b2,b3,b4) de la structure circulaire comportent une alternance de cellules déphasantes, et dans lequel la branche transversale (d) est une cellule déphasante en T ou en $\Pi$.

4. Dispositif selon la revendication 3, dans lequel, dans la structure circulaire, les cellules déphasantes des branches connectées sont formées de l'alternance de selfs de valeur L (b1,b3) et de capacités de valeur C (b2,b4) disposées symétriquement respectivement entre les ports primaires, dans lequel dans la branche transversale (d) la cellule en T (T2) est formée d'une capacité de valeur 4C à la masse disposée entre deux selfs de valeur L/2, ou bien la cellule en $\Pi$ ($\Pi$ 2) est formée d'une self de valeur L/2 disposée entre deux capacités de valeur 2C à la masse, et dans lequel les ports secondaires sont respectivement reliés à la masse à travers des capacités (17,17') de valeur 2C, et où le produit desdites valeurs L et C de self et capacité est lié à ladite fréquence centrale (fo).

5. Dispositif selon la revendication 1, dans lequel ledit coupleur, les premier et second circuits élémentaires déphaseurs connectés sont arrangés selon un circuit asymétrique en court-circuitant ledit second port primaire à la masse par une impédance nulle (Zo = 0), et en considérant une cellule L-C (K3), résultant de ce montage, comme un circuit ouvert.

6. Dispositif selon la revendication 5, dans lequel ledit coupleur comprend deux-branches (b1,b4) s'étendant du premier port primaire (P1) aux ports secondaires (P3,P4), formées respectivement d'une self de valeur L et d'une capacité de valeur C, et une branche transversale (d) s'étendant entre les deux ports secondaires (P3,P4) formée d'une cellule en T (T2) ou en $\Pi$ ($\Pi$ 2).

7. Dispositif selon la revendication 6, dans lequel dans la branche transversale la cellule en T est formée d'une capacité de valeur 4C à la masse disposée entre deux selfs de valeur L/2, ou bien la cellule en $\Pi$ ($\Pi$ 2) est formée d'une self de valeur L/2 entre deux capacités de valeur 2C à la masse.

8. Dispositif incluant un circuit amplificateur équilibré comprenant deux circuits coupleurs selon l'une des revendications 1 à 7 dont les ports secondaires sont connectés respectivement d'une part aux entrées et d'autre part aux sorties de deux circuits amplificateurs, les premiers ports primaires formant respectivement une entrée et une sortie de l'amplificateur équilibré.

9. Dispositif semiconducteur monolithiquement intégré incluant un dispositif selon l'une des revendications 1 à 8.

10. Dispositif réception radio-fréquences (RF) pour application aux télécommunications incluant un dispositif selon l'une des revendications 1 à 9.

11. Système pour télécommunications incluant un dispositif selon l'une des revendications 1 à 9.

## Claims

1. A device including a passive coupling circuit with lumped elements, for coupling a first AC signal having a given center frequency (fo) present on a first primary port (P1) to two second AC signals phase shifted through 180° present on two secondary ports (P3, P4), comprising a first and a second elementary 180° phase-shifting circuit (B, B') having a differential input terminal (1, 1') and a summation input terminal (2, 2'), and first and second output terminals (3, 4; 3', 4'), said elementary circuits being connected to each other, so that the differential input terminal (1) of the first circuit (B) feeds said first primary port (P1) and the differential input terminal (1') of the second circuit (B') feeds a second primary port (P'1) connected to ground via an impedance (Zo), in that the output terminals (3, 4; 4', 3') of the first and second circuits (B, B') are coupled crosswise and feed said secondary ports (P3, P4), and in that the summation input terminals (2, 2') are shortcircuited.

2. A device as claimed in Claim 1, in which in said coupling circuit the first and second connected elementary phase-shifting circuits are arranged according to a symmetrical circuit comprising four connected branches (b1, b2, b3, b4) forming a circular structure, with the primary and secondary ports respectively arranged diametrically opposite each other and symmetrically on said structure, and with a transversal branch (d) connecting the two secondary ports (P3, P4).

**3.** A device as claimed in Claim 2, in which the connected branches (b1, b2, b3, b4) of the circular structure have alternating phase shifting cells and in which the transversal branch (d) is a phase shifting cell T or $\pi$.

**4.** A device as claimed in Claim 3, in which in the circular structure the phase shifting cells of the connected branches are formed by alternating inductors of value L (b1, b3) and capacitors of value C (b2, b4) arranged symmetrically between the primary ports, in which device in the transversal branch (d) the cell T (T2) is formed by a capacitor having value 4C connected to ground inserted between two inductors having the value L/2, or the cell $\pi$ ($\pi$2) is formed by an inductor having the value L/2 inserted between two capacitors having value 2C connected to ground, and in which device the secondary ports are connected to ground across the respective capacitors (17, 17') having value 2C, and where the product of said values L and C of the inductor and capacitor is linked with said center frequency (fo).

**5.** A device as claimed in Claim 1, in which said coupler, the first and second connected phase shifter elementary circuits are arranged in an asymmetrical circuit short-circuiting said second primary port to ground via a zero impedance (Zo = 0), and while regarding a cell L-C (K3) which results from this structure, as an open circuit.

**6.** A device as claimed in Claim 5, in which said coupler comprises two branches (b1, b4) which stretch from the first primary port (P1) to the secondary ports (P3, P4) formed by an inductor having value L and a capacitor having value C respectively, and a transversal branch (d) stretching between the two secondary ports (P3, P4) formed by a cell T (T2) or $\pi(\pi2)$.

**7.** A device as claimed in Claim 6, in which the cell T in the transversal branch is formed by a capacitor having value 4C connected to ground inserted between two inductors having value L/2, or also the cell $\pi(\pi2)$ is formed by an inductor L/2 between two capacitors having the value 2C connected to ground.

**8.** A device including a balanced amplifier circuit comprising two coupling circuits as claimed in one of the Claims 1 to 7 whose secondary ports are connected to, on the one hand, the inputs and, on the other hand, to the outputs of two amplifier circuits, the first primary ports forming an input and an output respectively, of the balanced amplifier.

**9.** A monolithically integrated semiconductor device including a device as claimed in one of the Claims 1 to 8.

**10.** A radio frequency (RF) receiving device to be applied to telecommunications including a device as claimed in one of the Claims 1 to 9.

**11.** A telecommunications system including a device as claimed in one of the Claims 1 to 9.

## Patentansprüche

**1.** Vorrichtung mit einer passiven Kopplungsschaltung mit lokalisierten Elementen, um ein erstes Wechselstromsignal mit bestimmter Mittelfrequenz (fo), vorhanden an einem ersten primären Port (P1), mit zwei zweiten um 180° phasenverschobenen Wechselstromsignalen, vorhanden an zwei sekundären Ports (P3,P4), zu koppeln, mit einer ersten und einer zweiten um 180° phasenverschiebenden Elementarschaltung (B,B') mit respektive einem Differenz-Eingangspol (1,1') und einem Summier-Eingangspol (2,2'), und ersten und zweiten Aus-gangspolen (3,4;3',4'), wobei die besagten Elementarschaltungen derart zusammen geschaltet sind, dass der Differenz-Eingangspol (1) der ersten Schaltung (B) den besagten ersten primären Port (P1) liefert, der Differenz-Eingangspol (1') der zweiten Schaltung (B') einen zweiten primären Port (P'1) liefert, über eine Impedanz (Zo) mit der Masse verbunden, dass die Ausgangspole (3,4;4',3') der ersten und der zweiten Schaltung (B,B') respektive kreuzweise gekoppelt sind und die besagten sekundären Ports (P3,P4) liefern, und dass die Summier-Eingangspole (2,2') kurzgeschlossen sind.

**2.** Vorrichtung nach Anspruch 1, wobei in der besagten Kopplung die erste und zweite angeschlossene phasenverschiebende Elementarschaltung in einer symmetrischen Schaltung mit vier Zweigen (b1, b2, b3, b4) angeordnet sind, die eine kreisförmige Struktur bildet, mit den primären und sekundären Ports respektive diametral entgegengesetzt und symmetrisch in der besagten Struktur angeordnet, und mit einem transversalen Zweig (d) zum Anschluss der beiden sekundären Ports (P3,P4).

**3.** Vorrichtung nach Anspruch 2, in der die angeschlossenen Zweige (b1, b2, b3, b4) eine Wechselfolge phasenverschiebender Zellen enthält und in der der transversale Zweig (d) eine in T oder in $\Pi$ phasenverschiebende Zelle ist.

4. Vorrichtung nach Anspruch 3, wobei in der kreisförmigen Struktur die angeschlossenen phasenverschiebenden Zellen der Zweige aus einer Wechselfolge von Selbstinduktivitäten des Wertes L (b1, b3) und aus Kapazitäten des Wertes C (b2, b4) gebildet werden, respektive symmetrisch zwischen den primären Ports angeordnet, in dem im transversalen Zweig (d) die Zelle in T (T2) aus einer Kapazität des Wertes 4C an der Masse gebildet wird, angeordnet zwischen zwei Selbstinduktivitäten des Wertes L/2, oder aber die Zelle in $\Pi$ ($\Pi$ 2) wird aus einer Selbstinduktivität des Wertes L/2 gebildet, angeordnet zwischen zwei Kapazitäten des Wertes 2C an der Masse, und in der die sekundären Ports respektive über die Kapazitäten (17,17') des Wertes 2C mit der Masse verbunden sind und wo das Produkt der besagten Werte L und C von Selbstinduktivität und Kapazität mit der besagten Mittelfrequenz (fo) verbunden ist.

5. Vorrichtung nach Anspruch 1, in der die besagte Kopplung der ersten und zweiten angeschlossenen phasenverschiebenden Elementarschaltungen in einer asymmetrischen Schaltung angeordnet sind, indem der besagte zweite primäre Port über eine Impedanz Null (Zo = 0) mit der Masse kurzgeschlossen wird, und unter Betrachtung einer Zelle L-C (K3), aus dieser Anordnung hervorgehend, als offene Schaltung.

6. Vorrichtung nach Anspruch 5, in der die besagte Kopplung zwei Zweige (b1, b4) aufweist, die sich vom ersten primären Port (P1) zu den sekundären Ports (P3,P4) erstrecken, respektive gebildet aus einer Selbstinduktivität des Wertes L und einer Kapazität des Wertes C, und aus einem transversalen Zweig (d), der sich zwischen den beiden sekundären Ports (P3,P4) erstreckt, gebildet aus einer Zelle in T (T2) oder in $\Pi$ ($\Pi$2).

7. Vorrichtung nach Anspruch 6, in der der transversale Zweig der Zelle in T aus einer Kapazität des Wertes 4C an der Masse gebildet wird, angeordnet zwischen zwei Selbstinduktivitäten des Wertes L/2, oder aber die Zellen in $\Pi$ ($\Pi$ 2) aus einer Selbstinduktivität des Wertes L/2 zwischen zwei Kapazitäten des Wertes 2C an der Masse gebildet wird.

8. Vorrichtung mit einer abgeglichenen Verstärkerschaltung mit zwei Kopplungsschaltungen nach einem der Ansprüche 1 bis 7, wobei die sekundären Ports respektive einerseits an den Eingängen und andererseits an den Ausgängen von zwei Verstärkerschaltungen angeschlossen sind, und die ersten primären Ports respektive einen Eingang und einen Ausgang der abgeglichenen Verstärkerschaltung bilden.

9. Integrierte monolithische Halbleiteranordnung mit einer Vorrichtung nach einem der Ansprüche 1 bis 8.

10. Hochfrequenzanordnung (HF) zur Anwendung in der Telekommunikation mit einer Vorrichtung nach einem der Ansprüche 1 bis 9.

11. Telekommunikationssystem mit einer Vorrichtung nach einem der Ansprüche 1 bis 9.

FIG.1A

FIG.1B

FIG.1C

FIG.2A

FIG.2B

FIG.2C

FIG.3A

FIG.3B

FIG.3C

FIG.3D

FIG.4 A

FIG.4 B

FIG.5A

FIG.5B

FIG.5C

FIG. 6

FIG.7A

FIG.7B

FIG.8A

FIG.8B

FIG.9